Europäisches Patentamt

European Patent Office

Office européen des brevets

(11) Publication number: **0 069 484**
**B1**

(12) **EUROPEAN PATENT SPECIFICATION**

(45) Date of publication of patent specification: **30.01.85**

(51) Int. Cl.⁴: **G 06 F 1/00**

(21) Application number: **82303085.3**

(22) Date of filing: **15.06.82**

(54) Misoperation prevention circuit.

(30) Priority: **18.06.81 JP 94282/81**

(43) Date of publication of application:
**12.01.83 Bulletin 83/02**

(45) Publication of the grant of the patent:
**30.01.85 Bulletin 85/05**

(84) Designated Contracting States:
**DE FR GB**

(56) References cited:
**EP-A-0 023 124**
**EP-A-0 025 194**

**ELECTRONIC ENGINEERING, vol.51, no.627,
September 1979,**
**ELECTRONIC ENGINEERING, vol. 51, no. 627,
September 1979, "Power-on reset/run circuits
for the CDP1802muP"**

(73) Proprietor: **FUJITSU LIMITED**
**1015, Kamikodanaka Nakahara-ku
Kawasaki-shi Kanagawa 211 (JP)**

(72) Inventor: **Iwasaki, Tomonobu FUJITSU LIMITED
Patent Department 1015 Kamikodanaka
Nakahara-ku Kawasaki-shi Kanagawa 211 (JP)**

(74) Representative: **Sunderland, James Harry et al
HASELTINE LAKE & CO Hazlitt House 28
Southampton Buildings Chancery Lane
London WC2A 1AT (GB)**

## Description

This invention relates to a misoperation prevention circuit which prevents misoperations by placing a circuit to which clock signals are supplied in an operational mode only after the oscillation output of an oscillation circuit generating the clock signals has stabilised, after triggering of the oscillation circuit.

Low power consumption is an important requirement which CMOS LSI integrated circuits, for example CMOS LSI microprocessors, must fulfil. To meet this requirement, when such an IC need not be maintained in an operational condition (in which internal logic circuitry of the IC is operational) supply of clock signals to the internal logic circuitry of the IC is suspended and the IC placed in a standby mode, in response to an externally generated standby control signal. Simultaneously, operations of an oscillation circuit which generates the basic clock signals are terminated.

In the standby mode the internal logic circuitry of the IC ceases operation and the oscillation circuit ceases oscillation. For example, in the case of a microprocessor, processing ceases, (each register in the microprocessor retains the state which it held before processing ceases) in the standby mode and oscillation also ceases. In particular in the case of a CMOS IC, switching operations are not effected in the standby mode and as a result no current flows and low power consumption is achieved.

The use of a crystal resonator or a ceramic resonator, for example, for an oscillation element of the oscillation circuit means that after a termination of operations of the oscillation circuit at least several tens of milli-seconds are needed before the oscillation output of the oscillation circuit is stabilised after triggering (restoration of operations of) the oscillation circuit.

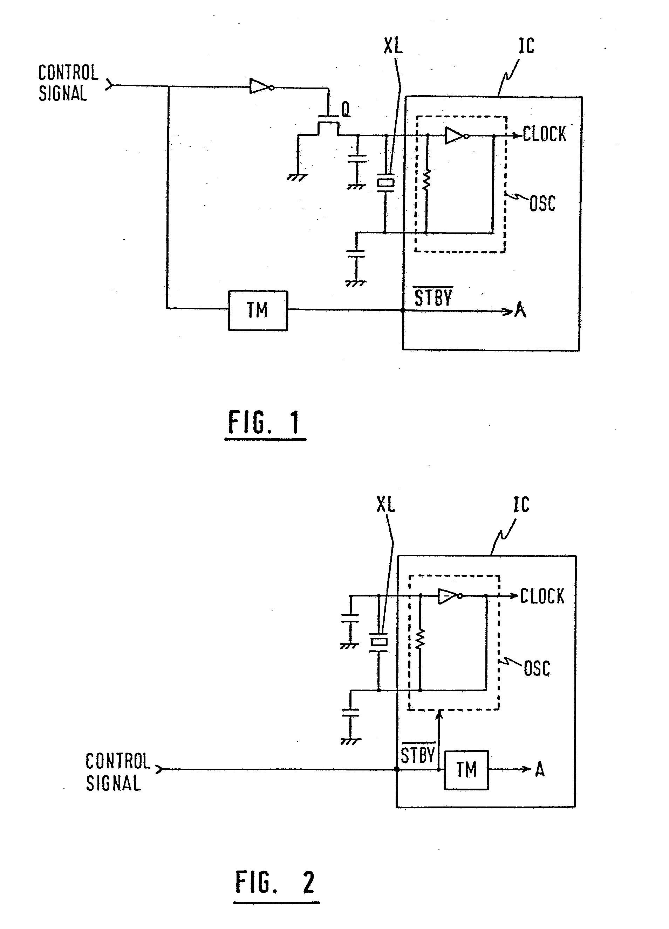

In order to prevent misoperation of internal logic circuitry, that circuitry must be restored to the operational condition only after the oscillation output of the oscillation circuit is stabilised. To allow for the delay before oscillation output is stabilised, previously proposed CMOS LSI IC's having a standby mode are adapted so that internal logic circuitry is restored to the operational mode (ready for operations) only after a specified constant period (corresponding to the above-mentioned delay), from the triggering of the oscillation circuit, using structures as illustrated in Figure 1 and Figure 2 of the accompanying drawings, which are schematic block diagrams. cf also Electronic Engineering, Vol. 51, No. 627, September 1979, page 25.

In Figures 1 and 2, IC is an integrated circuit, OSC is an oscillation circuit, XL is a crystal resonator, TM is a timer, $\overline{\text{STBY}}$ is a standby control terminal, A is a signal delivered to internal logic circuitry of the IC for controlling starting and stopping of operations thereof, and CLOCK is a clock output. In Figure 1, Q is a transistor.

Figure 1 illustrates a structure in which the oscillation circuit OSC is triggered in response to a control signal, through action of the transistor Q. The control signal is delivered to transistor Q through an inverter. The control signal is also delivered to the timer TM which provides a desired delay. The internal circuitry of the IC is restored to the operational condition by an output (A) of the timer TM which is delivered from the time a specified period of time after the input of the control signal to the transistor Q and to the timer. The structure of Figure 1 has the disadvantage that relatively many circuitry elements external to the IC are required.

In the structure of Figure 2 the timer TM is incorporated within the IC and as compared with Figure 1 the majority of circuitry elements external to the IC are eliminated. The structure of Figure 2 performs operations similar to those of Figure 1, but as will be apparent from Figure 2 the circuit configuration of the IC is made more complicated by the presence of the timer and variations in time delay before stabilisation of oscillation output cannot be accommodated because the delay time of the timer cannot be changed.

According to the present invention there is provided a misoperation prevention circuit, for circuitry including

an oscillation circuit for generating clock signals, and

a main circuit arranged for receiving the clock signals,

in which circuitry operations of the oscillation circuit can be terminated so that clock signals are no longer supplied to the main circuit, and the main circuit can be placed in a standby mode,

the misoperation prevention circuit being operable, in response to a control signal, to restore operations of the oscillation circuit, after termination thereof, and subsequently to restore the main circuit to an operational mode only after a selected period of time, sufficient for stabilisation of the oscillation circuit, has elapsed,

characterised in that the misoperation prevention circuit comprises:—

an integrating circuit operable in response to the control signal to deliver an integration signal of a level which changes as time passes,

a first gate circuit, having an input connected to receive the integration signal, an output connected to the oscillation circuit, and a first threshold level, operable to deliver from its output a signal for restoring operations of the oscillation circuit when the integration signal reaches the first threshold level, and

a second gate circuit, having an input connected to receive the integration signal, an output connected to the main circuit, and a second threshold level, operable to deliver from its output a signal for restoring the main circuit to the operational mode when the integration signal subsequently reaches the second threshold level, the selected period of time after the integration signal reaches the first threshold level.

The present invention avoids the above-mentioned disadvantages and provide for restoration of an operational mode using a simplified structure with fewer elements.

An embodiment of the present invention has an integrating circuit which receives a control signal and which provides an output for triggering the oscillation circuit. Two gate circuits which have different threshold levels are arranged to receive the output of the integrating circuit. One gate circuit triggers the oscillation circuit when the output of the integrating circuit reaches a lower threshold level, and the other gate circuit brings the circuit to which clock signals are supplied from the oscillation circuit into operation when the output of the integrating circuit reaches a higher threshold level when a specified period of time has elapsed after triggering of the oscillation circuit.

Embodiments of the present invention can be particularly effective when applied to IC's which comprise both an oscillation circuit and internal logic circuitry. Embodiments of the present invention can be applied to microprocessors, and also to other devices having circuitry which operates in synchronization with clock signals and which can operate erroneously if the circuitry is started up whilst clock signal oscillation is unstable.

Embodiments of the present invention may be employed with oscillation circuits using crystal or ceramic resonators, and can also be employed with CR (capacitance-resistance) oscillation circuits.

Reference is made, by way of example, to the accompanying drawings, in which:—

Figures 1 and 2 are schematic block diagrams illustrating respective previously proposed misoperation prevention circuits.

Figure 3 is a schematic block diagram illustrating a misoperation prevention circuit embodying the present invention,

Figure 4 is a graph for assistance in explanation of operations of the circuit of Figure 3.

Figure 5 is a schematic block diagram illustrating a microprocessor IC having a misoperation prevention circuit embodying the present invention,

Figure 5(a) is a diagram for assistance in understanding Figure 5, and

Figure 6 is a waveform diagram illustrating signal waveforms developed in Figure 5.

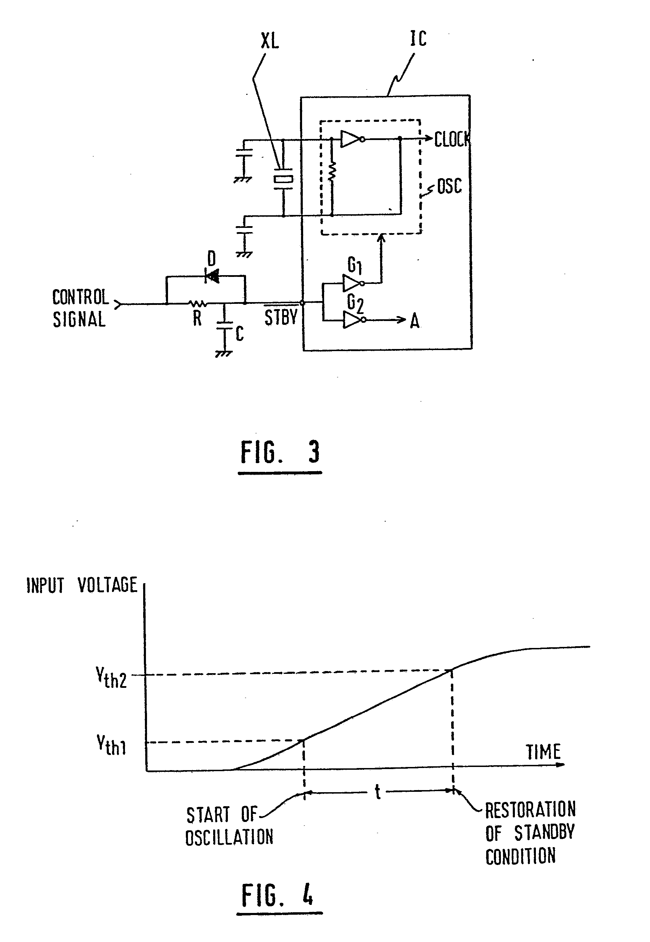

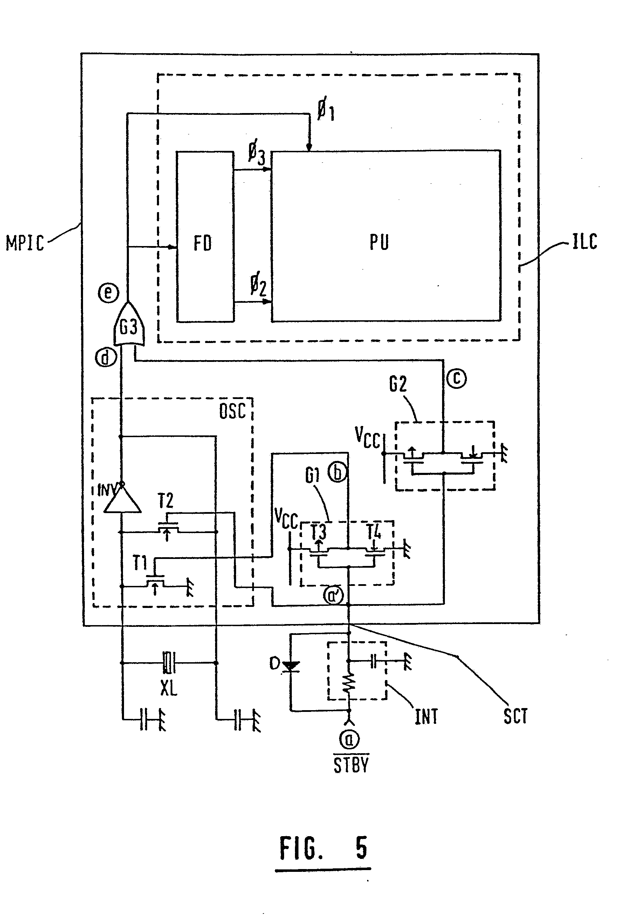

In Figure 3, IC, CLOCK, XL, OSC, $\overline{STBY}$, and A correspond to items similarly labelled in Figures 1 and 2, D is a diode, R is a resistor, C is a capacitor, and $G_1$ and $G_2$ are inverters.

In the graph of Figure 4 input voltage applied to the standby control terminal $\overline{STBY}$ of Figure 3 is represented along the vertical axis and time is represented along the horizontal axis. $V_{th1}$ is the threshold level of inverter $G_1$ and $V_{th2}$ is the threshold level of inverter $G_2$. These threshold levels have the relationship $V_{th1} < V_{th2}$, since in this embodiment of the present invention, the input voltage applied to $\overline{STBY}$ increases with time.

Although the inverters $G_1$ and $G_2$ are provided within the IC in this embodiment of the present invention, their threshold levels can be changed, for example by changing the channel width or channel length of MOS transistors which constitute the inverters. R and C in Figure 3 together form an integrating circuit. When a control signal (high level) for restoration of the operational condition is delivered to the integrating circuit, the integrating circuit delivers to the standby control terminal $\overline{STBY}$ an integration signal which provides an input voltage at that terminal which rises as time passes, as illustrated in Figure 4, in this embodiment of the present invention.

When the input voltage reaches the threshold level $V_{th1}$ of the inverter $G_1$, that inverter operates and delivers a signal which triggers the oscillation circuit OSC. The input voltage continues to rise and when it reaches the threshold level $V_{th2}$ of inverter $G_2$ that inverter operates and delivers the control signal A which restores the internal circuitry of the IC to the operational conditions. For example the control signal A may control a gate circuit through which clock signals must pass to reach the internal circuitry.

The delay t (Figure 4) between the time at which the input voltage reaches $V_{th1}$ and the time at which the input voltage reaches $V_{th2}$ corresponds to the period required for stabilisation of the oscillation output of the oscillation circuit OSC. Thus, the internal circuitry of the IC is not restored to the operational mode until the oscillation output is stabilised, thereby avoiding misoperation.

Thus, when the control signal applied to the integrating circuit becomes high level, to restore the operational condition of the IC, the output voltage of the integrating circuit changes as shown in Figure 4. Thereby, the output of inverter $G_1$ (having a low threshold level) is first inverted, to trigger the oscillation circuit OSC, and then after the specified period t, when the output voltage of the integrating circuit exceeds the threshold level $V_{th2}$, the output of inverter $G_2$ is inverted, to restore the operational condition of the internal circuitry of the IC.

The time constant of the integrating circuit and the threshold levels $V_{th1}$, $V_{th2}$ are set in such a way that the delay time t is sufficient to allow stabilisation of the oscillation output.

The diode D is provided so that when the control signal applied to the integrating circuit becomes low level the input voltage applied to the standby control terminal $\overline{STBY}$ is immediately brought to a low level.

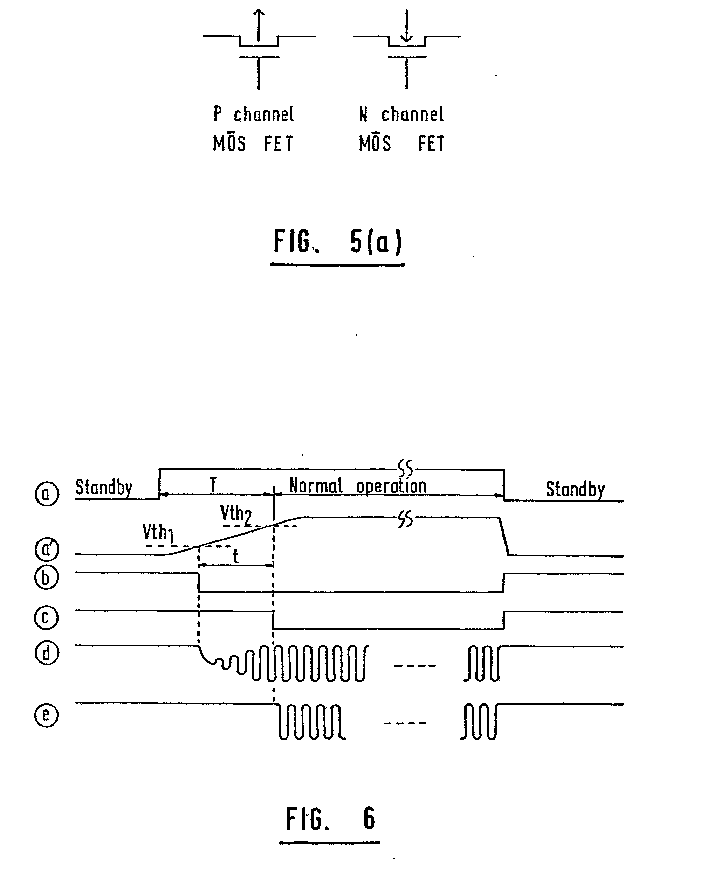

In Figure 5, MPIC is a microprocessor IC which incorporates internal logic circuitry ILC, an oscillation circuit OSC and gate circuits $G_1$ to $G_3$. Gate circuits $G_1$ and $G_2$ correspond to the inverters $G_1$ and $G_2$ of Figure 3, whilst $G_3$ is a gate circuit through which the oscillation output of the oscillation circuit OSC must pass to reach the internal logic circuitry ILC. INT is an integrating circuit to which an external signal $\overline{STBY}$ is supplied. SCT is a standby control terminal of the microprocessor IC MPIC. XL is a crystal resonator. $V_{cc}$ is a supply voltage. INV is an inverter. D is a diode.

In Figure 5, $T_1$ to $T_4$ are MOS FET's. Figure 5(a) is for assistance in understanding Figure 5 and illustrates the symbols employed in Figure 5 to indicate N-channel MOS FET's and P-channel MOS FET's.

Figure 6 is a waveform diagram in which waveforms ⓐ, ⓐ′, ⓑ, ⓒ, ⓓ, ⓔ illustrate signal waveforms which appear at respective correspondingly labelled circuit points in Figure 5.

The signal $\overline{STBY}$ is set at a low level when the microprocessor IC is to be maintained in a standby mode, and is switched to a high level when the microprocessor IC is to be placed in a normal operational mode (see Figure 6, waveform ⓐ).

When the signal $\overline{STBY}$ is switched from low to high level the output of the integrating circuit INT gradually increases from a low level to a high level over a period of time (see Figure 6, waveform ⓐ′).

The output of the integrating circuit INT is supplied to the gate circuit $G_1$, comprising transistors $T_3$ and $T_4$ which are respectively a P-channel MOS FET and N-channel MOS FET (see Figure 5(a)). The gate circuit $G_1$ has a preselected threshold level $V_{th1}$. Whilst the output of the integrating circuit INT is below the threshold level $V_{th1}$ the output of the gate circuit $G_1$ is at high level, but when the output of the integrating circuit reaches $V_{th1}$ the output of the gate circuit $G_1$ is switched to low level (see Figure 6, waveform ⓑ).

Transistors $T_1$ and $T_2$ of the oscillation circuit OSC are controlled respectively by the output of the gate circuit $G_1$ and the output of the integrating circuit INT.

When the output of the integrating circuit INT is low level and the output of the gate circuit $G_1$ is high level, $T_2$ is OFF and $T_1$ is ON. The input to the inverter INV is fixed to low level and the oscillation circuit OSC does not oscillate.

When the output of the integrating circuit INT is high level and the output of the gate circuit $G_1$ is low level, $T_2$ is ON and $T_1$ is OFF. The resistance appearing when $T_2$ is conductive is used as a feedback resistance in the oscillation circuit OSC and the oscillation circuit produces an oscillation output (see Figure 6, waveform ⓓ).

The output of the integrating circuit INT is also supplied to gate circuit $G_2$, comprising a P-channel MOS FET and a N-channel MOS FET. Gate circuit $G_2$ has a preselected threshold level $V_{th2}$ which is higher than $V_{th1}$.

When the output of the integrating circuit INT reaches $V_{th1}$ and the output of the gate circuit $G_1$ is switched to low level, the output of gate circuit $G_2$ (see Figure 6, waveform ⓒ) remains at high level for a period t until the output of the integrating circuit INT reaches $V_{th2}$. During the period t, the output of the gate circuit (OR-gate) $G_3$ (which receives the output of oscillation circuit OSC and the output of gate circuit $G_2$) is fixed at high level. The internal logic circuitry ILC thus does not receive oscillation signals (see Figure 6, waveform ⓔ).

When the output of the integrating circuit INT reaches $V_{th2}$, after the period t, the output of the gate circuit $G_2$ changes to low level (see Figure 6, waveform ⓒ) and oscillation signals from the oscillation circuit OSC are passed through the gate circuit $G_3$ to the internal logic circuitry ILC, which commences operation.

It will be seen from the waveforms of Figure 6 that during the period t the operation of the oscillation circuit OSC is unstable. Only when the oscillation circuit OSC is oscillating stably after the period t, are clock signals supplied to the internal logic circuitry ILC, thereby preventing misoperation of that logic circuitry.

The internal logic circuitry ILC comprises a frequency divider FD which derives internal clock signals $\emptyset_1$, $\emptyset_2$, $\emptyset_3$ from the oscillation output of the oscillation circuit OSC. The internal clock signals are utilised by a processing unit PU of the internal logic circuitry ILC.

When the microprocessor IC is to be switched from the normal operational mode to the standby mode, the signal $\overline{STBY}$ is switched from high to low level. The diode D connected across the integrating circuit INT immediately returns the output of the integrating circuit to low level (see Figure 6, waveform ⓐ′) and the oscillation circuit OSC immediately ceases oscillation.

As explained above with reference to Figures 5 and 6, even when an externally supplied standby control signal $\overline{STBY}$ indicates that the normal operational mode should be restored, operations of the internal logic circuitry ILC are inhibited over a period T (see Figure 6 waveform ⓐ) until the oscillation output of the oscillation circuit becomes stable. Thereby misoperations can be prevented.

In the embodiment of Figure 5, operation of the internal logic circuitry ILC is inhibited by inhibiting the supply of clock signals (through control of gate circuit $G_3$ by the output of gate circuit $G_2$—which corresponds to the signal A of Figure 3) until the output of the integrating circuit ILC exceeds $V_{th2}$. Of course, other means can be used for inhibiting the operation of internal logic circuitry. For example, it is possible to directly supply clock signals to the internal logic circuitry and to effect control so that the internal logic circuitry does not commence operation when the output of gate circuit $G_2$ is high level, even though clock signals are being supplied.

The threshold levels of the gate circuits $G_1$ and $G_2$ can be changed so that the period of instability of the oscillation circuit OSC is matched. For example, the threshold level of $G_1$ can be increased by increasing the gm of transistor $T_3$ and decreasing the gm of transistor $T_4$.

It will be understood that in the embodiments of Figures 3 and 5, the crystal resonator XL can be replaced by a ceramic resonator or a CR circuit.

As explained above, an embodiment of the present invention is capable of restoring an IC to the operational mode without misoperation using very simplified circuitry. It will be appreciated that differences in times required for stabilisation of the oscillation output of oscillation circuits, due to fluctuations in characteristics of the oscillation elements, can be accommodated easily merely by changing the time constant of the integrating circuit.

## Claims

1. A misoperation prevention circuit, for circuitry (MPIC) including
an oscillation circuit (OSC) for generating clock signals, and
a main circuit (ILC) arranged for receiving the clock signals,
in which circuitry operations of the oscillation circuit can be terminated so that clock signals are no longer supplied to the main circuit, and the main circuit can be placed in a standby mode,
the misoperation prevention circuit being operable, in response to a control signal, to restore operations of the oscillation circuit, after termination thereof, and subsequently to restore the main circuit to an operational mode only after a selected period of time, sufficient for stabilisation of the oscillation circuit, has elapsed,
characterised in that the misoperation prevention circuit comprises:—
an integrating circuit (INT; D, R, C) operable in response to the control signal to deliver an integration signal of a level which changes as time passes,
a first gate circuit (G1), having an input connected to receive the integration signal, an output connected to the oscillation circuit, and a first threshold level, operable to deliver from its output a signal for restoring operations of the oscillation circuit when the integration signal reaches the first threshold level, and
a second gate circuit (G2) having an input connected to receive the integration signal, an output connected to the main circuit, and a second threshold level, operable to deliver from its output a signal for restoring the main circuit to the operational mode when the integration signal subsequently reaches the second threshold level, the selected period of time after the integration signal reaches the first threshold level.

2. A misoperation prevention circuit as claimed in claim 1, wherein the integrating circuit comprises a resistor and a capacitor and is operable to deliver the integration signal in response to a high level signal applied thereto as the control signal.

3. A misoperation prevention circuit as claimed in claim 2, wherein the integrating circuit further comprises a diode connected so that in response to a low level signal, applied in place of the high level signal, the integrating circuit delivers a fixed low level signal.

4. A misoperation prevention circuit as claimed in claim 1, 2 or 3, wherein the first and second gate circuits are constituted by respective inverters.

5. A misoperation prevention circuit as claimed in claim 1, 2, 3 or 4, wherein the oscillation circuit has either a crystal resonator or a ceramic resonator for its oscillation element.

6. A misoperation prevention circuit as claimed in any preceding claim, wherein the oscillation circuit, the main circuit and the first and second gate circuits are provided in an integrated circuit device.

7. A misoperation prevention circuit as claimed in claim 6, wherein the integrating circuit is provided externally of the integrated circuit device.

8. A misoperation prevention circuit as claimed in claim 6 or 7, wherein the main circuit is an internal logic circuit of the integrated circuit device.

9. A misoperation prevention circuit as claimed in claim 6, 7 or 8 wherein the integrated circuit device is a CMOS LSI device.

## Revendications

1. Circuit de prévention de défaillance destiné à une circuit (MPIC) comportant:
un circuit d'oscillation (OSC) servant à produire des signaux d'horloge, et
une circuit principal (ILC) conçu pour recevoir les signaux d'horloge,
dans lequel circuit (MPIC) le fonctionnement du circuit d'oscillation peut être arrêté de sorte que les signaux d'horloge ne sont plus délivrés au circuit principal et le circuit principal peut être placé dans un mode d'attente,
le circuit de prévention de défaillance ayant pour fonction, en réponse à un signal de commande, de remettre en service le circuit d'oscillation, après que celui-ci a été arrêté, et, ensuite, de ne ramener le circuit principal à une mode opérationnel qu'après une durée sélectionnée, suffisante pour la stabilisation du circuit d'oscillation, s'est écoulée,

caractérisé en ce que le circuit de prévention de défaillance comprend:

un circuit d'intégration (INT; D, R, C) ayant pour fonction, en réponse à un signal de commande, de délivrer un signal d'intégration dont le niveau varie avec le temps,

un premier circuit de porte ($G_1$), possédant une entrée connectée de façon à recevoir le signal d'intégration, une sortie connectée au circuit d'oscillation et un premier niveau de seuil, qui a pour fonction de délivrer à sa sortie un signal permettant de remettre en service le circuit d'oscillation lorsque le signal d'intégration a atteint le premier niveau de seuil, et

un deuxième circuit de porte ($G_2$), possédant une entrée connectée de façon à recevoir le signal d'intégration, une sortie connectée au circuit principal et un deuxième niveau de seuil, qui a pour fonction de délivrer à sa sortie un signal permettant de ramener le circuit principal au mode opérationnel lorsque le signal d'intégration a ultérieurement atteint le deuxième niveau de seuil, un certain temps, correspondant à la durée sélectionnée, après que le signal d'intégration a atteint le premier niveau de seuil.

2. Circuit de prévention de défaillance selon la revendication 1, où le circuit d'intégration comprend une résistance et un condensateur et a pour fonction de délivrer le signal d'intégration en réponse à un signal de niveau haut qui lui est appliqué au titre du signal de commande.

3. Circuit de prévention de défaillance selon la revendication 2, où le circuit d'intégration comprend en outre une diode connectée de façon que, en réponse à un signal de niveau bas, appliqué à la place signal de niveau haut, le circuit d'intégration délivre un signal de niveau bas fixe.

4. Circuit de prévention de défaillance selon la revendication 1, 2 ou 3, où les premier et deuxième circuits de porte sont respectivement constitués par des inverseurs.

5. Circuit de prévention de défaillance selon la revendication 1, 2, 3 ou 4, où le circuit d'oscillation possède, comme son élément d'oscillation, un résonateur à cristal ou un résonateur à céramique.

6. Circuit de prévention de défaillance selon l'une quelconque des revendications précédentes, où le circuit d'oscillation, le circuit principal et les premier et deuxième circuits de porte sont placés dans un dispositif de type circuit intégré.

7. Circuit de prévention de défaillance selon la revendication 6, où le circuit d'intégration est placé à l'exterieur du dispositif de type circuit intégré.

8. Circuit de prévention de défaillance selon la revendication 6 ou 7, où le circuit principal est un circuit logique interne du dispositif de type circuit intégré.

9. Circuit de prévention de défaillance selon la revendication 6, 7 ou 8, où le dispositif de type circuit intégré est un dispositif du type intégré à grande échelle à CMOS.

**Patentansprüche**

1. Schaltkreis zur Verhinderung von Fehloperationen für eine Schaltungsanordnung (MPIC) mit

einer Oszillatorschaltung (OSC) zur Erzeugung von Taktsignalen und

einer Hauptschaltung (ILC), die zum Empfang der Taktsignale ausgelegt ist,

bei welcher Schaltungsanordnung der Betrieb der Oszillatorschaltung beendet werden kann, so daß keine Taktsignale mehr zu der Hauptschaltung geliefert werden, und die Hauptschaltung in einen Bereitschaltsmodus gebracht werden kann,

wobei der Schaltkreit zur Verhinderung von Fehloperationen in Abhängigkeit von einem Steuersignal in Betrieb gesetzt werden kann, um den Betrieb der Oszillatorschaltung nach ihrer Beendigung wieder herzustellen, und um danach die Hauptschaltung nach einer ausgewählten Zeitperiode wieder in Betrieb zu setzen, die hinreichend lang für die Stabilisierung der Oszillatorschaltung ist,

dadurch gekennzeichnet, daß der Schaltkreis zur Verhinderung von Fehloperationen umfaßt:

eine Integrationsschaltung (INT; D, R, C), die in Abhängigkeit von dem Steuersignal tätig wird, um ein Integrationssignal zu liefern, dessen Pegel sich mit der Zeit ändert,

eine erste Torschaltung (G1), deren einer Eingang zum Empfang des Integrationssignals angeschlossen ist, deren einer Ausgang mit der Oszillatorschaltung verbunden ist und die einen ersten Schwellenwertpegel hat, der dazu verwendet werden kann, von ihrem Ausgang ein Signal zur Wiederherstellung des Betriebs der Oszillatorschaltung zu liefern, wenn das Integrationssignal einen ersten Schwellenwertpegel erreicht, und

eine zweite Torschaltung (G2), mit einem Eingang der zum Empfang des Integrationssignals angeschlossen ist, einem Ausgang der mit der Hauptschaltung verbunden ist, und die einen zweiten Schwellenwertpegel hat, der im Betrieb von seinem Ausgang ein Signal zur Weiderherstellung der Hauptschaltung in den Operationsmodus liefern kann, wenn das Integrationssignal danach der zweiten Schwellenwertpegel erreicht, nach der vorbestimmten Zeitperiode nachdem das Integrationssignal den ersten Schwellenwertpegel erreicht hat.

2. Schaltkreit zur Verhinderung von Fehloperationen nach Anspruch 1, bei welchem die Integrationsschaltung einen Widerstand und einen Kondensator umfaßt und im Betrieb das Integrationssignal in Abhängigkeit von einem Großsignal, das ihm als Steuersignal zugeführt wird, liefern kann.

3. Schaltkreis zur Verhinderung von Fehloperationen nach Anspruch 2, bei welchem die Integrationsschaltung ferner eine Diode umfaßt, die so angeschlossen ist, daß die Integrationsschaltung in Abhängigkeit von einem Kleinsignal, welches anstelle des Großsignals zugeführt wird, ein festes Kleinsignal liefert.

4. Schaltkreis zur Verhinderung von Fehloperationen nach Anspruch 1, 2 oder 3, bei welchem die erste und die zweite Torschaltung durch entsprechende Inverter gebildet sind.

5. Schaltkreis zur Verhinderung von Fehloperationen nach Anspruch 1, 2, 3 oder 4, bei welchem die Oszillatorschaltung entweder einen Kristallresonator oder einen keramischen Resonator als oszillierendes Element umfaßt.

6. Schaltkreis zur Verhinderung von Fehloperationen nach einem der vorhergehenden Ansprüche, bei welchem die Oszillatorschaltung, die Hauptschaltung und die erste und die zweite Torschaltung in einen integrierten Schaltungseinrichtung vorgesehen sind.

7. Schaltkreis zur Verhinderung von Fehloperationen nach Anspruch 6, bei welchem die Integrationsschaltung außerhalb der integrierten Schaltungseinrichtung vorgesehen ist.

8. Schaltkreis zur Verhinderung von Fehloperationen nach Anspruch 6 oder 7, bei welchem die Hauptschaltung eine interne Logikschaltung der integrierten Schaltungseinrichtung ist.

9. Schaltkreis zur Verhinderung von Fehloperationen nach Anspruch 6, 7 oder 8, bei welchem die integrierte Schaltungseinrichtung eine CMOS LSI Einrichtung ist.

FIG. 1

FIG. 2

FIG. 3

FIG. 4

**FIG. 5**

0 069 484

P channel
MOS FET

N channel
MOS FET

## FIG. 5(a)

(a) Standby | T | Normal operation | Standby

(a') Vth$_1$ Vth$_2$ t

(b)

(c)

(d)

(e)

## FIG. 6

4